# EUROPEAN PATENT APPLICATION

(11) **EP 1 043 925 A2**
(43) Date of publication of application: **11.10.2000**
(21) Application number: 00303010.3
(22) Date of filing: 10.04.2000
(51) Int. Cl.: H05K 13/04

(54) **High speed die transfer system and method**

(30) Priority: 09.04.1999 ZA 9902625
(71) Applicant: Supersensor (Proprietary) Limited, Goodwood 7460 (ZA)
(72) Inventor: Kruger, Johan Dawid, Witkoppen, 2068 (ZA)
(74) Representative: Pratt, David Martin

(57) **Abstract**

A system 10 for automatically transferring a plurality of devices onto a plurality of circuits comprises a main drum 22 for feeding a continuous substrate 20 comprising a plurality of circuits 14.1 to 14.n provided thereon. The circuits collectively provide a first set of positions being respective device placement positions for receiving devices. A device transfer drum 34 cooperates with the main drum to transfer the devices onto the substrate in a device transfer region 48. The device transfer drum comprises means for carrying the devices in a second set of positions, respective ones of the first set of positions being associated with respective ones of the second set of positions. The system also comprises drive means 31 for driving the main drum 34 and the device transfer drum such that sequential positions in the first set of positions are in register with their associated positions in the second set of positions in said device transfer region, to transfer the devices onto the substrate in the respective device placement positions.

## Description

THIS invention relates to systems for and methods of assembling electronic products comprising a circuit onto which there is to be mounted at least one electronic device. The invention more particularly relates to a system for and a method of transferring the device onto the circuit.

In this specification the term "device" will be used to include a die separated from a wafer, a packaged integrated circuit, an electronic component etc. The term "circuit" will be used to include a substrate comprising conductive leads and/or tracks and/or active and/or passive electronic components thereon.

Prior art systems and methods of assembling such electronic products include the steps of manually or semi-manually picking a die from a wafer or other form of presentation; transferring the device along a complex path; and locating and securing the device in a selected placement position on the circuit. This method is too slow and cumbersome for large production runs, and is usually only used in prototyping situations. Pick-and-place equipment including a gantry, an optical or visual guidance system and a robotic arm for picking the device from the wafer or other form of presentation, transferring it to a predetermined placement position on the circuit and locating and securing it in that position is also known. The methods used by these systems are also too slow for very large production runs of relatively cheap electronic products (such as radio frequency (RF) transponder tags) of which very large volumes are required. A third known and sophisticated system comprises a revolving turret or so-called chip shooter which may be able to handle the volume and rate of production required. However, it is believed that the cost occasioned by the preparation, feeding and presentation of the devices and circuits to this type of equipment would increase the unit cost of a RF transponder tag significantly.

### OBJECT OF THE INVENTION

Accordingly it is an object of the present invention to provide an alternative system for and method of transferring a device onto an electronic circuit with which the applicant believes the aforementioned disadvantages may at least be alleviated.

### SUMMARY OF THE INVENTION

According to the invention there is provided a system for automatically transferring a plurality of devices onto a plurality of circuits, the system comprising:
- means for feeding a continuous substrate comprising a plurality of circuits provided thereon;
- the circuits collectively providing a first set of positions being respective device placement positions for receiving devices;
- a device transfer drum cooperating with the feeding means to transfer devices onto the substrate in a device transfer region;
- the device transfer drum comprising means for carrying devices in a second set of positions, respective ones of the first set of positions being associated with respective ones of the second set of positions; and
- means for driving one or more of the feeding means and the device transfer drum such that sequential positions in the first set of positions are in register with their associated positions in the second set of positions in said device transfer region, to transfer the devices onto the substrate in the respective device placement positions.

The feeding means preferably comprises a main feed drum cooperating with the device transfer drum in the die transfer region.

The system may further comprise a circuit applicator station for applying the circuits onto the substrate upstream from the device transfer region.

The circuit applicator station may comprise a further drum cooperating with the main drum to apply the circuits onto the substrate, as the substrate moves about the main drum.

The further drum may form part of a printing station for printing an antenna for each circuit onto the substrate. The antennas may be printed utilizing a screen-printing process.

The system may further comprise a substrate storage reel upstream from the device transfer region on which the substrate is stored and from which it is paid out in use to pass through the device transfer region; and a substrate collection reel downstream of the device transfer region.

The further drum and device transfer drum may have the same diameter which preferably is smaller than a diameter of the main drum.

The aforementioned drive means may be arranged also to drive said further drum.

The drive means may include a gear arrangement driven by an electric motor to rotate the main drum and/or the device transfer drum and/or the further drum. Alternatively and/or in addition stepper or servo motors may be utilized.

Also included within the scope of the present invention is a method of automatically transferring a plurality of devices onto a plurality of circuits, the method comprising the steps of:
- causing a substrate carrying a plurality of circuits provided thereon to be fed through a device transfer region;
- the circuits collectively providing a first set of positions being respective device placement positions for receiving devices;
- carrying devices to be transferred on a device transfer drum in a second set of positions, respective positions of the first set of positions being associated with respective positions of the second set of positions;
- causing sequential positions in the first set of positions to be in register with their associated positions in the second set of positions in the device transfer region; and
- transferring the devices onto the circuits in the device placement positions.

The substrate may be fed about a main drum and the devices are preferably carried circumferentially on the device transfer drum.

In a preferred from of the invention, antennas for the circuits are applied to the substrate upstream of the device transfer region.

### BRIEF DESCRIPTION OF THE ACCOMPANYING DIAGRAMS

The invention will now further be described, by way of example only, with reference to the accompanying diagrams wherein:
- figure 1: is a diagrammatic representation of the system according to the invention; and
- figure 2: is a plan view of a flexible substrate carrying a plurality of circuits.

### DESCRIPTION OF A PREFERRED EMBODIMENT OF THE INVENTION

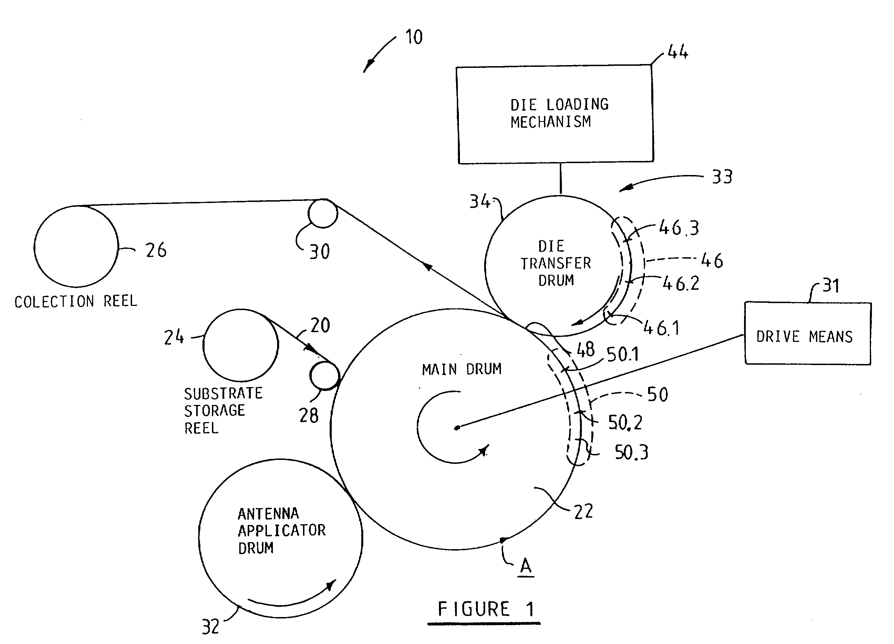

The system according to the invention for transferring a device in the form of a die onto a circuit is generally designated by the reference numeral 10 in figure 1.

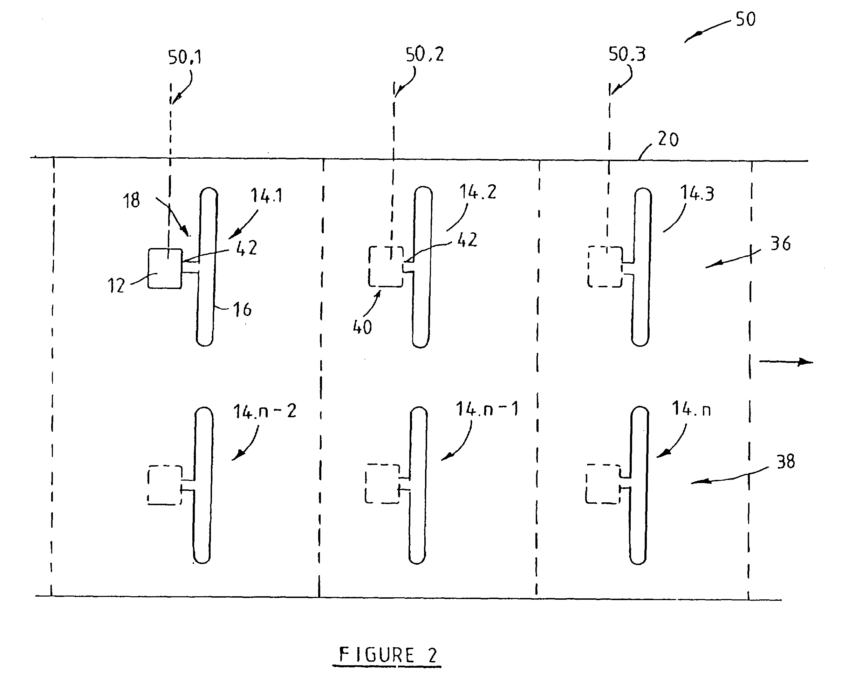

Referring to figure 2, the system 10 is particularly useful for high speed, continuous, automatic and sequential transferring of naked dies 12 or packaged integrated circuits (not shown) onto flexible circuits 14.1 to 14.n comprising antennas 16 to form radio frequency (RF) transponders 18. The circuits 14.1 to 14.n are provided on, or from part a flexible substrate 20.

Referring to figure 1, the system 10 includes a main drum 22 for feeding the substrate 20. The substrate, which is stored on reel 24, is fed in an anti-clock wise direction A about drum 22, to a collection reel 26. The substrate is paid out from reel 24 and fed about the main drum 22 as hereinbefore described, while it is supported by support rollers 28 and 30. The main drum is driven by drive means 31. In other embodiments, instead of or in addition to the main drum, the substrate may be fed along a planar bed, for example.

The system further includes an antenna application station in the form of an antenna applicator drum 32 cooperating with drum 22 to apply in sequential manner antennas 16 in spaced relationship relative to one another on the moving substrate 20.

The system yet further includes a die transfer station 33 comprising a die transfer drum 34. Die transfer drum 34 cooperates with the main drum 22 to apply, also in sequential manner, a die 12 to each of the circuits 14.1 to 14.n on the substrate.

In use, a substrate 20 moves in direction A about drum 22, rotating antenna applicator drum 32 applies the antennas 16 in spaced relation on the substrate 20 as shown in figure 2, to define a first set 50 of indexed 50.1 to 50.3 die placement positions 40 adjacent electrical contacts 42 of the antennas 16. Two or more parallel rows 36 and 38 of antennas may be applied. The antennas may be applied utilizing any known application technique, such as screen printing for example. In other embodiments the antennas may have been pre-applied (for example by etching techniques) on the substrate, which is stored on and paid out from storage reel 24.

The die transfer station 33 further comprises means 44 for loading dies to be transferred by drum 34 onto the circumference of drum 34 in a second set 46 of predetermined indexed positions 46.1 to 46.3 and at a predetermined pitch. The loading means 44 may include an arrangement including a plurality (typically two) pick and place arrangements (not shown) working in tandem. The dies 12 may be secured to the circumference of drum 34 and released therefrom by a suction system (also not shown). The positions 46.1 to 46.3 and pitch of the dies on the drum 34 are controlled such that a die next to be transferred is in register with an associated indexed placement position 50.1 to 50.3 on the substrate, as the rotating drum 34 and substrate moves through stationary die transfer region 48 shown in figure 1. Any suitable known re-registering technique may be utilized in this regard.

In the contact or die transfer region, the dies are released by the suction system from drum 34 and transferred onto substrate 20 where they are applied to the substrate by an adhesive or the like so that electrical contacts on the dies 12 are in contact with the contacts 42 of the antennas 16. In a preferred embodiment, the diameter of drum 32 is the same as that of drum 34, but smaller than that of drum 22 and the rotation of drums 32 and 34 is synchronized with that of drum 22 by mechanical means including accurately profiled meshing gear teeth, so that successive dies on the drum 34 are in register with successive placement positions 40 on the substrate in the transfer region 46. In other embodiments, one or more of the drums may be driven by electric stepper or servo motors (not shown).

The substrate 20 with dies 12 and antennas 16 mounted thereon are collected on reel 26. It will be appreciated that with a high speed rotating system a high transfer rate of dies onto the substrate may be achieved.

The transponder tags 14.1 to 14.n may be severed from the continuous substrate 20 stored on reel 26.

It will be appreciated that there are many variations in detail on the system and method according to the invention, without departing from the scope and spirit of the appended claims.

## Claims

1. A system for automatically transferring a plurality of devices onto a plurality of circuits, the system comprising:
- means for feeding a continuous substrate comprising a plurality of circuits provided thereon;
- the circuits collectively providing a first set of positions being respective device placement positions for receiving devices;
- a device transfer drum cooperating with the feeding means to transfer devices onto the substrate in a device transfer region;
- the device transfer drum comprising means for carrying devices in a second set of positions, respective ones of the first set of positions being associated with respective ones of the second set of positions; and
- means for driving one or more of the feeding means and the device transfer drum such that sequential positions in the first set of positions are in register with their associated positions in the second set of positions in said device transfer region, to transfer the devices onto the substrate in the respective device placement positions.

2. A system as claimed in claim 1, wherein the feeding means comprises a main feed drum cooperating with the device transfer drum in the die transfer region.

3. A system as claimed in any one of claims 1 and 2 comprising a circuit applicator station for applying the circuits onto the substrate upstream from the device transfer region.

4. A system as claimed in claim 3 wherein the circuit applicator station comprises a further drum cooperating with the main drum to apply the circuits onto the substrate, as the substrate moves about the main drum.

5. A system as claimed in claim 4 wherein the further drum forms part of a printing station for printing an antenna for each circuit onto the substrate.

6. A system as claimed in any one of the preceding claims comprising a substrate storage reel upstream from the device transfer region on which the substrate is stored and a substrate collection reel downstream of the device transfer region.

7. A system as claimed in any one of claims 2 to 6 wherein a diameter of the device transfer drum is smaller than a diameter of the main drum.

8. A method of automatically transferring a plurality of devices onto a plurality of circuits, the method comprising the steps of:
- causing a substrate carrying a plurality of circuits provided thereon to be fed through a device transfer region;
- the circuits collectively providing a first set of positions being respective device placement positions for receiving devices;
- carrying devices to be transferred on a device transfer drum in a second set of positions, respective positions of the first set of positions being associated with respective positions of the second set of positions;
- causing sequential positions in the first set of positions to be in register with their associated positions in the second set of positions in the device transfer region; and
- transferring the devices onto the circuits in the device placement positions.

9. A method as claimed in claim 8 wherein the substrate is fed about a main drum and the devices are carried circumferentially on the device transfer drum.

10. A method as claimed in claim 8 or claim 9 wherein antennas for the circuits are applied to the substrate upstream of the device transfer region.
